# EUROPEAN PATENT SPECIFICATION

(11) **EP 1 950 320 B1**
(45) Date of publication and mention of the grant of the patent: **03.10.2012**
(21) Application number: 07123659.0
(22) Date of filing: 19.12.2007
(51) Int. Cl.: C23C 14/00, F01D 5/28

(54) **Method for restoring or regenerating an article and restored regenerated article**
Verfahren zur Ausbesserung eines Artikels und ausbesserter Artikel
Procédé pour rétablir ou régénérer un article et article régénéré rétabli

(30) Priority: 29.12.2006 US 648494; 29.12.2006 US 648493
(43) Date of publication of application: 30.07.2008
(73) Proprietor: GENERAL ELECTRIC COMPANY, Schenectady, NY 12345 (US)
(72) Inventor: MALY, Michael Patrick, Cincinnati, IL 45205 (US); CARTER, Jr., William Thomas, Galway, NY 12074 (US); KELLY, Thomas Joseph, Cincinnati, OH 45241 (US); VELIZ, Mark David, Washington, IL 61571 (US)
(74) Representative: Williams, Andrew Richard

(56) References cited:
- EP-A- 1 217 090
- EP-A- 1 591 561
- EP-A- 1 752 559

## Description

This invention relates generally to restored or regenerated articles, particularly gas turbine engine components, and methods for restoring or regenerating articles.

Higher operating temperatures of gas turbine engines are continuously sought in order to increase their efficiency. However, as operating temperatures increase, the high temperature durability of the components of the engine must correspondingly increase. While significant advantages in high temperature capabilities have been achieved through formulation of nickel and cobalt-base superalloys, such alloys alone are often inadequate to form turbine components located in certain sections of a gas turbine engine. A common solution is to thermally insulate such components (e.g., turbine blades, vanes) in order to reduce their service temperatures. For this purpose, thermal barrier coatings have been applied over the metal substrate of turbine components exposed to high surface temperatures.

Thermal barrier coatings typically comprise a ceramic layer that overlays a metal substrate comprising a metal or metal alloy. Various ceramic materials have been employed as the ceramic layer, for example, chemically (metal oxide) stabilized zirconias such as yttria-stabilized zirconia, scandia-stabilized zirconia, calcia-stabilized zirconia, and magnesia-stabilized zirconia. The thermal barrier coating of choice is typically a yttria-stabilized zirconia ceramic coatings, such as, for example, about 7% yttria and about 93% zirconia.

In order to promote adhesion of the ceramic layer to the underlying metal substrate and to prevent oxidation thereof, a bond coat layer is typically formed on the metal substrate from an oxidation-resistant overlay alloy coating such as MCrAlY where M can be iron, cobalt, and/or nickel, or from an oxidation-resistant diffusion coating such as an aluminide, for example, nickel aluminide and platinum aluminide. Depending upon the bond coat layer used, the thermal barrier coating can be applied on the bond coat layer by thermal spray techniques or by physical vapor deposition (PVD) techniques.

In certain instances, the turbine component simply requires environmental protection from the oxidizing atmosphere of the gas turbine engine, as well as other corrosive agents that are present. In such instances, a diffusion coating such as a platinum aluminide, nickel aluminide, or simple aluminide coating can be applied to the metal substrate.

Although significant advances have been made in improving the durability of thermal barrier coatings, as well as diffusion coatings used for environmental protection, such coatings will typically require removal and repair under certain circumstances. For example, thermal barrier coatings, as well as diffusion coatings, can be susceptible to various types of damage, including objects ingested by the engine, erosion, oxidation, and environmental attack.

Removal of protective coatings may result in removal of some of the underlying metal substrate. Removal of the underlying metal substrate is particularly acute with diffusion coatings and diffusion bond coat layers because such coatings/layers diffuse and extend into the metal substrate surface, forming a diffusion zone. Also, during operation of the gas turbine engine, the diffusion zone can increase in thickness, consuming even more of the underlying metal substrate.

Repeated repair/recoat processes are associated with subsequent material loss. Additionally, component areas may be worn down by erosion or environmental attack during engine operation. The material loss due to field service and repair processing may result in the component being under minimum wall thickness, causing the component to be scrapped.

EP 1217090 discloses a method of vapour deposition repair of superalloy articles. A repair filler material is applied to a defect after removalof an original coating.

Thus, there exists a need in the art for improved processes for repairing turbine components, particularly those comprising airfoils, in order to increase repair opportunities by minimizing loss of the underlying substrate.

The above-mentioned need or needs may be addressed by exemplary embodiments that provide a restored or regenerated component.

According to a first aspect of the invention, there is provided a method comprising: a) providing a residual substrate comprised of a first material; b) depositing a layer comprised of a second material overlying at least a portion of the residual substrate, wherein the second material is substantially similar in composition to the first material, wherein the residual substrate and the layer of second material comprise a body of a component; c) depositing an environmental coating onto the body by a deposition process; characterised in that: for step (b), the layer is deposited by a deposition process selected from vapor phase deposition, ion plasma deposition, cathodic arc deposition, sputtering and combinations thereof; for step (c), the deposition process is selected from vapor phase deposition, cathodic arc deposition, and combinations thereof; the method further comprising: d) utilizing a heat treatment to promote the formation of an integral bond between the residual substrate and the layer at an interface therebetween, wherein the heat treatment includes exposing the residual substrate and the deposited layer to temperatures of between 816 °C to 1260 °C for between 2 to 24 hours.

Preferably, the method further comprises e) treating a surface of the coated body with a surface treatment process such that the surface of the coated body acquires at least one desired surface characteristic.

The method may further comprise f) prior to (b), evaluating a wall thickness of the residual substrate as compared to a predetermined minimum wall thickness, wherein an amount of second material deposited in (b) is at least partly dependent on the evaluated wall thickness, wherein if the evaluated wall thickness is less than the predetermined minimum wall thickness, the second material is deposited in an amount sufficient to provide at least the minimum wall thickness.

The method may also further comprise g) subsequent to (c), utilizing the coated component (36) in a gas turbine engine.

The method may further comprise h) subsequent to (g), removing the deposited environmental coating and at least a portion of the deposited layer.

The method may still further comprise i) subsequent to (h), repeating steps (b)-(d).

Preferably, the article further comprises a surface having at least one desired surface characteristic being the result of a suitable surface treatment.

The subject matter which is regarded as the invention is particularly pointed out and distinctly claimed in the concluding part of the specification. The invention, however, may be best understood by reference to the following description taken in conjunction with the accompanying drawing figures in which:
FIG. 1 is a schematic representation of an exemplary process for restoring a worn component having a residual substrate with a wall thickness greater than or equal to a minimum wall thickness.
FIG. 2 is a schematic representation of an exemplary system for regenerating a worn component having a residual substrate with a wall thickness less than a minimum wall thickness.
FIG. 3 provides a flow chart showing exemplary processes for restoring or regenerating a worn component.
FIG. 4 is a schematic representation of an exemplary process for restoring or regenerating a worn component.

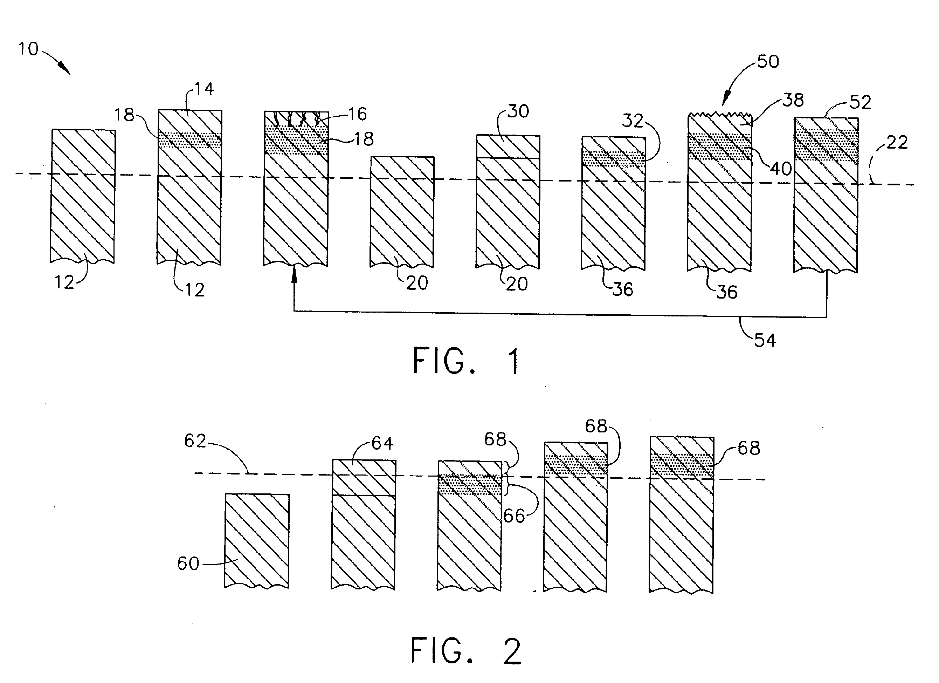

Referring to the drawings wherein identical reference numerals denote the same elements throughout the various views, FIG. 1 illustrates an exemplary repair method for a component for a gas turbine engine.

In general terms, in an exemplary method, a turbine engine component, generally denoted 10, such as a high pressure turbine blade, may require repair due to wear, cracks, environmental effects, and the like. In an exemplary method, the component 10 includes a base substrate 12 and an environmental coating 14. After being in service, the component 10 may exhibit cracks 16 or wear requiring repair. In an exemplary method, component 10 is stripped of any prior thermal barrier coating, if present (not shown) and environmental coating 14 (i.e., aluminide). For purposes of this disclosure, those with skill in the art will understand the term "environmental coating" also encompasses the term "bond coat" to be used with a thermal barrier coating (TBC).

The thermal barrier coating, if present, may be removed by any suitable means. The environmental coating 14 may be a diffusion coating wherein a diffusion zone 18 forms at the interface of the coating and the underlying material. During the stripping process, the environmental coating, including the diffusion zone 18 is removed. In an exemplary method, the aluminide coating/diffusion zone is chemically stripped, although any process sufficient to remove the coating may be utilized.

After stripping, the component comprises a residual substrate 20 comprising the base material. During an initial repair process, the wall thickness of the residual substrate 20 (after stripping) may be above the minimum allowable thickness, denoted by dashed line 22. However, with known restoration/repair techniques, each subsequent repair reduces wall thickness of the component by removing the base material that has been consumed in the diffusion zone.

One problem addressed in the disclosed exemplary embodiments is that of subsequently thinning walls. Generally speaking, in an exemplary method, an amount of additional (i.e., restorative) material 30 is deposited to the residual substrate 20 prior to re-application of a coating. The additional material 30 is substantially similar to the base material in composition so that an integral interface 32 may be formed between the residual substrate 20 and the additional material 30. As explained in greater detail below, the additional material may be deposited in a cathodic arc deposition process such as an ion plasma deposition. Alternately, other techniques, such as sputtering, may be used. As used in this disclosure, the term "additional material" signifies material added to an underlying substrate 20 that retains at least the minimum wall thickness. Thus, the additional material 30 is intended to be non-structural (i.e., not load bearing).

In an exemplary embodiment, the compositional compatibility between the residual substrate 20 and the additional material 30 provides the potential for an integral interface, generally denoted 32, therebetween. In an exemplary method, the integral interface 32 is at least partly formed during a heat treatment process as described in greater detail below.

In an exemplary method a suitable deposition technique is used to apply the additional material 30 to the residual substrate 20. Unlike a coating, the additional material 30 is substantially similar to the material of the residual substrate 20. Suitable deposition techniques include those that deposit from a vapor or plasma directly, and not from a liquid or solid phase, such that interfacial boundaries are minimized between the residual substrate and the additional material.

In exemplary methods, the additional material 30 may be applied in a vapor deposition process such as chemical vapor deposition, physical vapor deposition (PVD), and cathodic arc vapor deposition. Chemical vapor deposition involves introducing reactive gaseous elements into a deposition chamber containing one or more substrates to be coated. Physical vapor deposition involves providing a source material and a substrate to be coated in an evacuated deposition chamber. The source material is converted into vapor by an energy input, such as heating by resistive, inductive, or electron beam means. Cathodic arc vapor deposition is a known technique for applying various coatings, such as metals, nitrides, oxides, or carbides to a substrate. The raw material for the cathodic arc deposition process is a cathode. The cathode is placed in a vacuum chamber. Direct current is caused to flow from the cathode into the vacuum chamber, and subsequently into an anode. Localized heating occurs at the point at which the current leaves the cathode, termed the cathode spot. The high temperature at the cathode spot causes local evaporation and ejection of metal ions and particles from the cathode face, creating a cloud in front of the cathode.

When a substrate is passed through this cloud, impinging ions and particles will adhere to the substrate, building a layer thereon.

Additionally, in exemplary methods, the additional material 30 may be applied by sputtering techniques. Suitable sputtering techniques include direct current diode sputtering, radio frequency sputtering, ion beam sputtering, reactive sputtering, magnetron sputtering, steered arc sputtering, and the like. The additional material may be deposited using a combination of deposition techniques.

The additional material 30 is deposited by the selected technique to a thickness adequate to provide the restored component with a desired wall thickness. In an exemplary embodiment, the deposition of the additional material 30 occurs following an initial stripping of the component such that the wall thickness of the residual base substrate 20 is above the minimum wall thickness 22. Thus, the additional material 30 is not intended to function as a "load bearing" structure, as will be appreciated by those with skill in the art.

In an exemplary method, the residual substrate 20 and the additional material 30 form a body 36 of a restored component. The body 36 is subsequently coated with a "new" environmental coating 38. The deposited coating may be platinum aluminide, nickel aluminide, aluminide, and the like, intended as an environmental coating, or as a bond coat for a thermal barrier coating. The environmental coating may be deposited by a suitable deposition process. In an exemplary embodiment, the coating is deposited by a vapor phase deposition process or a cathodic arc deposition process.

In an exemplary embodiment, the environmental coating 38 is a "diffusion coating" which forms a "new" diffusion zone 40 with the underlying component. In an exemplary method, the diffusion zone 40 substantially consumes the additional material 30. Thus, in an exemplary method, the additional material is termed a "sacrificial diffusion layer." In an exemplary method, the diffusion zone 40 encompasses at least about 75% of the additional material.

In an exemplary method, the coated component (i.e., residual substrate, additional material, environmental coating) is returned to service until a subsequent repair is required. During the subsequent repair process, the environmental coating (including the formed diffusion zone) is removed. In an exemplary method, the diffusion zone extends into the layer of additional material that had been deposited onto the residual substrate. In an exemplary method, the subsequent stripping process removes the diffusion zone, without removing additional residual substrate 20. Thus, the prior deposition of additional material 30, which had been substantially consumed by the diffusion zone 40, permits repair of the component without further loss of the residual substrate 20. Because the component can undergo multiple repair cycles, the component's overall service life is potentially extended.

In an exemplary method, the residual substrate 20 and the additional material 30 are substantially integrally bonded through a heat treatment process. In exemplary embodiments, because the composition of the residual substrate and the composition of the additional material are substantially similar, a substantially integral interface 32 may be formed therebetween. In an exemplary embodiment, the heat treatment process is conducted under conditions sufficient to diffuse the deposited additional material and the residual base material at the interface. For example, the heat treatment process may be conducted under vacuum, at temperatures of between about 1500 °F and 2300 °F (816 °C- 1260 °C) for a time between about 2 hours to about 24 hours. In an exemplary method, the heat treatment process is conducted under vacuum for a time between about 2 hours to about 6 hours. In an exemplary method, the heat treatment process is conducted for a time between about 2 hours and about 4 hours. In an exemplary method, the heat treatment process is conducted at temperatures between about 1800 °F to about 2000 °F (about 982 °C to about 1093 °C). In an exemplary method, the heat treatment process is conducted at temperatures between about 1850 °F to about 1975 °F (about 1010 °C to about 1079 °C). In an exemplary embodiment, the heat treatment to enhance the bond between the deposited additional material and the residual substrate occurs prior to deposition of the environmental coating. An additional heat treatment may be performed after the environmental coating deposition. In other exemplary embodiments, the heat treatment is provided after deposition of the environmental coating.

In an exemplary embodiment, the environmental coating is an aluminide applied in a vapor phase deposition process. In an exemplary method, the heat treatment process to intimately bond the residual substrate with the additional material may occur during the vapor phase deposition of the aluminide coating. Thus, an additional heat treatment process may be avoided. In an exemplary method, the aluminide coating forms a diffusion zone with the underlying additional material during the deposition process.

In some cases, the heat treatment process may lead to contamination at the surface of the component, shown generally at 50. The surface contamination can be removed by a grit blast polish or other process to provide a surface 52 having desired surface characteristics. As indicated by arrow 54, following additional service, the restored component may be in need of additional repair.

In an exemplary method, the material of the residual substrate is adapted for high temperature applications. In an exemplary method, the residual substrate material is a single-crystal alloy such as Rene N'5 superalloy material. The additional material is substantially similar to the material of the residual substrate, (e.g., Rene N'5 superalloy material). Other high temperature material may be utilized in exemplary methods. For example, the residual substrate material may be Rene 142 superalloy material. The additional material may also be Rene 142 superalloy material. Exemplary methods may also employ other materials for forming components as will be appreciated by those having skill in the art.

In an exemplary method, the residual substrate may have a wall thickness under a predetermined minimum thickness. In usual prior situations, the component would be scrapped. However, in an exemplary method, the component may be regenerated and returned to service. FIG. 2 illustrates an exemplary regenerative process. In an exemplary embodiment, a residual substrate 60 has a wall thickness less than a predetermined minimum wall thickness, illustrated by line 62. In an exemplary embodiment, additive (i.e., regenerative) material 64 is provided to increase the wall thickness to at least the predetermined minimum thickness. As used in this disclosure, the term "additive material" signifies material added to an underlying substrate that has a wall thickness less than the requisite minimum wall thickness. Thus, the additive material includes at least a portion 66 that is intended to be structural (i.e., load bearing). The additive material further includes a portion 68 that is intended to form the sacrificial diffusion layer as earlier described. In an exemplary method, less than about 75% of the additive material is intended to be consumed as a sacrificial diffusion layer. In an exemplary embodiment, the additive material is substantially similar in composition to the material of the residual substrate, thus potentially forming an integral bond at the interface thereof.

In an exemplary method, sufficient additive material 64 is provided to increase the wall thickness to greater than the predetermined minimum thickness. In an exemplary embodiment, the additive material is deposited onto the residual substrate 60 by a cathodic arc deposition process such as ion plasma deposition. Other suitable deposition techniques, such as sputtering, may also be employed.

In order to return the component to service, an environmental coating may be provided. In an exemplary method, the environmental coating is an aluminide-type diffusion coating applied via a vapor phase deposition process. In the vapor phase deposition process, the regenerated component (residual substrate plus additive material) is surrounded by aluminum-containing donor pellets and heated in an argon atmosphere. The diffusion aluminide coating provides a high concentration of aluminum at the surface, which allows for the formation of an adherent, passivating oxide film on the surface.

Following additional service, the coated regenerated component may be repaired as explained above. For example, the environmental coating may be stripped, including the diffusion zone that extends into the sacrificial portion of the additive material. A renewed layer of sacrificial material is deposited, and a renewed environmental coating is deposited. The component undergoes appropriate heat treatment processes and surface preparation before returning to service.

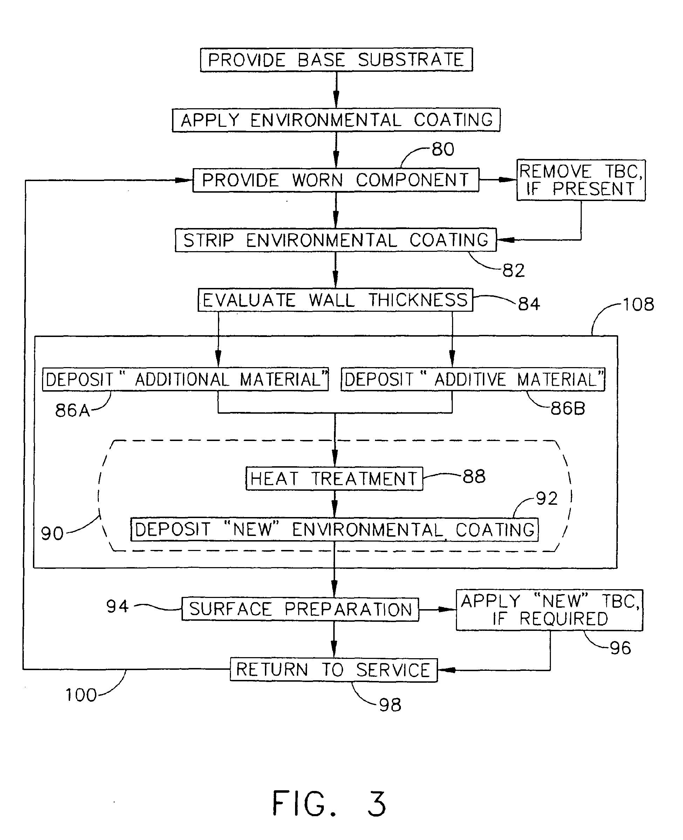

Exemplary methods are summarized in FIG. 3. A worn component in need of repair is provided in step 80. A thermal barrier coating (TBC), if present, is removed by techniques known to those will skill in the art. In step 82, the environmental coating (or bond coat) is stripped, leaving a residual substrate. The wall thickness of the substrate is evaluated in step 84. An amount of material, substantially similar in composition to the material of the residual substrate, is deposited. If the evaluated wall thickness meets or exceeds the minimum wall thickness, then "additional" or restorative material is added, as in step 86A. If the evaluated wall thickness is less than the predetermined minimum wall thickness, then "additive" or regenerative material is added, as in step 86B. Subsequent to the deposition of the restorative or regenerative material, the component is subjected to a heat treatment process in step 88. As illustrated by dashed line 90, step 88 may occur substantially simultaneously with step 92 in which a "new" environmental coating is deposited. For example, the deposition conditions, e.g., temperature, may be sufficient to supply the requisite heat treatment to promote an integral bond at the interface of the added material and the residual substrate. In an exemplary method, the coated component undergoes at least one surface treatment in step 94. If desired, the coated component may have a thermal barrier coating applied, as in step 96. The component is returned to service in step 98. Thereafter, when the component requires repair, the process may be repeated as illustrated by arrow 100.

An exemplary repair process may generally include two basic steps. A first step is cathodic arc deposition of a nickel base superalloy onto a component that has been stripped of a prior environmental coating. The deposition of the superalloy may be additional (restorative) material added as a sacrificial diffusion layer, or it may be additive (regenerative) material, as earlier described. A second step is a subsequent cathodic arc deposition of a renewed environmental coating (or bond coat) such as aluminum or nickel aluminide. In an exemplary method, the two sequential steps are performed in a combined operation within a cathodic arc coater. Since both depositions generally occur under vacuum conditions, the combined operation can occur without breaking the requisite vacuum. A first cathodic arc deposition adds material to residual substrate material. The added material may be merely intended as sacrificial material, or a portion of the added material may be intended to be structural. A second cathodic arc deposition provides a suitable aluminide or other environmental coating.

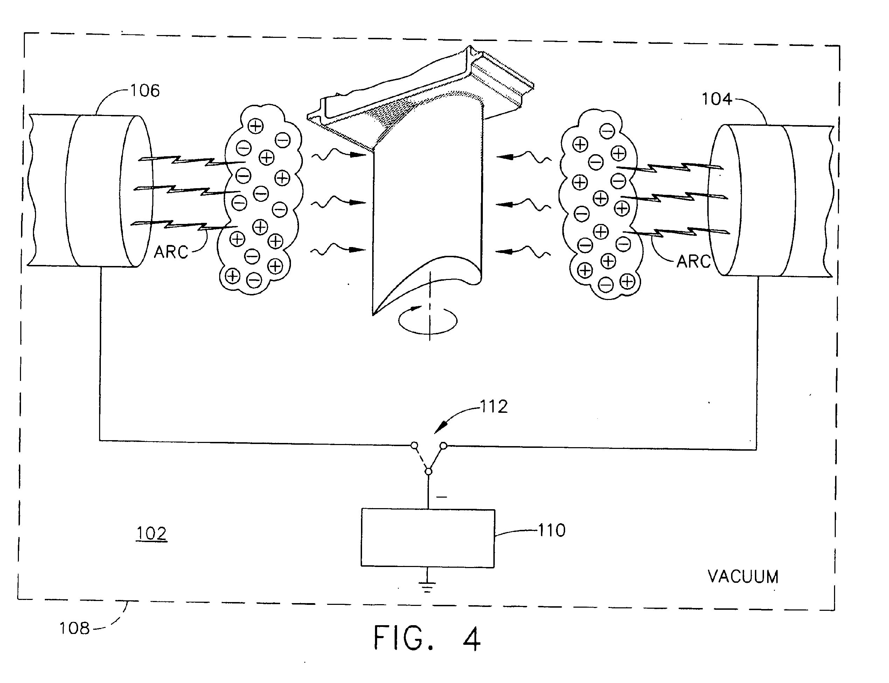

As illustrated in FIG. 4, in an exemplary embodiment, a cathodic arc deposition chamber 102 is modified such that a subset of the available cathodes is active at any one time. During the deposition, the active cathodes are switched from one set to another. In an exemplary embodiment, one or more first cathodes 104 comprise a first deposition material. The first deposition material is selected so as to be substantially similar in composition to the material of the residual substrate. The first deposition material may be, for example, a nickel-based superalloy.

In an exemplary embodiment, one or more second cathodes 106 comprise a second deposition material. The second deposition material is able to form an environmental coating on the restored/regenerated component. For example, the second deposition material is a suitable coating alloy.

In an exemplary embodiment, the two deposition steps are accomplished in a single process cycle, as illustrated in FIGS. 3 and 4 by dashed line 108. Referring again to FIG. 4, deposition chamber 102 is operated under suitable vacuum and temperature conditions for depositing the first deposition material onto the residual substrate. Without breaking the vacuum or cooling the restored/regenerated component, the second deposition material is deposited thereon.

An exemplary method, using a single cathodic arc deposition chamber, provides benefits of reducing the required number of process steps. The quality of the restored/regenerated and coated component is improved because exposure to air or other contaminants is minimized. An additional heating step prior to deposition of the environmental coating is eliminated.

In an exemplary method, a single electric power source 110 may be utilized. A switching mechanism 112 may be used to switch between powering the first and second cathodes.

### EXAMPLES

A button (substrate) comprising Rene N'5 superalloy is provided. A layer of additional Rene N'5 superalloy is deposited onto the substrate via a cathodic arc deposition process. A diffusion coating of aluminum is applied to the layer of additional Rene N'5 superalloy by ionic plasma deposition. The coated button is subjected to a heat treatment process (1975 °F (1079 °C) for 4 hours) followed by surface treatment.

A layer of additional R'142 superalloy is applied via ionic plasma deposition to a test button. The button plus additional material is subjected to a heat treatment process. Following the heat treatment process, an aluminide diffusion coating is deposited in a vapor phase deposition process.

A N'5 superalloy button has additional N'5 superalloy deposited thereon by an ion plasma deposition process. An aluminide diffusion coating is deposited via a vapor phase deposition process.

The examples show promising results in providing integral bonding between the button substrate and the additional material deposited thereon. Additionally, the examples form a bonding diffusion zone at the coating/superalloy interface. The heat treatment can be performed before, during, or after deposition of the aluminide coating. Surface treatment following coating deposition enhances surface characteristics of the coating.

This written description uses examples to disclose aspects of the invention, and also to enable any person skilled in the art to make and use the invention. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. A method comprising:
a) providing a residual substrate (20, 60) comprised of a first material;
b) depositing a layer (30, 64) comprised of a second material overlying at least a portion of the residual substrate, wherein the second material is substantially similar in composition to the first material, wherein the residual substrate and the layer of second material comprise a body of a component (36);
c) depositing an environmental coating (38) onto the body by a deposition process;
wherein
for step (b), the layer is deposited by a deposition process selected from vapor phase deposition, ion plasma deposition, cathodic arc deposition, sputtering and combinations thereof;
for step (c), the deposition process is selected from vapor phase deposition, cathodic arc deposition, and combinations thereof the method further comprising:
d) utilizing a heat treatment to promote the formation of an integral bond between the residual substrate and the layer at an interface (32) therebetween, wherein the heat treatment includes exposing the residual substrate and the deposited layer to temperatures of between 816 °C to 1260 °C for between 2 to 24 hours.

2. The method according to claim 1 further comprising:
e) treating a surface (52) of the coated body with a surface treatment process such that the surface of the coated body acquires at least one desired surface characteristic.

3. The method according to claim 1 or 2 further comprising:
f) prior to (b), evaluating a wall thickness of the residual substrate (20,60) as compared to a predetermined minimum wall thickness, wherein an amount of second material deposited in (b) is at least partly dependent on the evaluated wall thickness, wherein if the evaluated wall thickness is less than the predetermined minimum wall thickness, the second material is deposited in an amount sufficient to provide at least the minimum wall thickness.

4. The method according to any preceding claim, further comprising:
g) subsequent to (c), utilizing the coated component (36) in a gas turbine engine.

5. The method according to claim 4 further comprising:
h) subsequent to (g), removing the deposited environmental coating (38) and at least a portion of the deposited layer.

6. The method according to claim 5 further comprising:
i) subsequent to (h), repeating steps (b)-(d).

## Patentansprüche

1. Verfahren, mit den Schritten:
a) Bereitstellen eines ein erstes Material aufweisenden Restsubstrates (10, 60);
b) Abscheiden einer ein zweites Material aufweisenden Schicht (30, 64) über wenigstens einem Abschnitt des Restsubstrates, wobei das zweite Material im Wesentlichen in der Zusammensetzung dem ersten Material ähnlich ist, wobei das Restsubstrat und die Schicht des zweiten Materials einen Körper einer Komponente (36) ausbilden;
c) Abscheiden einer Umgebungsschutzbeschichtung (38) auf dem Körper durch einen Abscheidungsprozess;
wobei:
für Schritt (b) die Schicht durch einen Abscheidungsprozess abgeschieden wird, der aus Dampfphasenabscheidung, Ionenplasmaabscheidung, Kathodenlichtbogenabscheidung, Sputtern und Kombinationen davon ausgewählt wird;
für Schritt (c) der Abscheidungsprozess aus Dampfphasenabscheidung, Kathodenlichtbogenabscheidung und Kombinationen davon ausgewählt wird und das Verfahren ferner die Schritte aufweist:
d) Anwenden einer Wärmebehandlung, um die Ausbildung einer integrale Bindung zwischen dem Restsubstrat und der Schicht an einer Grenzfläche (32) dazwischen zu fördern, wobei die Wärmebehandlung die Aussetzung des Restsubstrates und der abgeschiedenen Schicht an Temperaturen zwischen 816 °C bis 1260 °C für 2 bis 24 Stunden beinhaltet.

2. Verfahren nach Anspruch 1, ferner mit dem Schritt:
e) Behandeln einer Oberfläche (52) des beschichteten Körpers mit einem Oberflächenbehandlungsprozess dergestalt, dass die Oberfläche des beschichteten Körpers wenigstens eine gewünschte Oberflächeneigenschaft annimmt.

3. Verfahren nach Anspruch 1 oder 2, ferner mit dem Schritt:
f) vor dem Schritt (b) Untersuchen einer Wanddicke des Restsubstrates (20, 60) im Vergleich zu einer vorbestimmten minimalen Wanddicke, wobei eine Menge des in (b) abgeschiedenen zweiten Materials wenigstens teilweise von der untersuchten Wanddicke abhängt, wobei, wenn die untersuchte Wanddicke dünner als die vorbestimmte minimale Wanddicke ist, das zweite Material in einer ausreichenden Menge abgeschieden wird, um wenigstens die minimale Wanddicke zu erzeugen.

4. Verfahren nach einem der vorstehenden Ansprüche, ferner mit dem Schritt:
g) anschließend an (c), Anwenden der beschichteten Komponente (36) in einer Gasturbinenmaschine.

5. Verfahren nach Anspruch 4, ferner mit dem Schritt:
h) anschließend an (g), Entfernen der abgeschiedenen Umgebungsschutzbeschichtung (38) und wenigstens eines Teils der abgeschiedenen Schicht.

6. Verfahren nach Anspruch 5, ferner mit den Schritten:
i) anschließend an Schritt (h), Wiederholen der Schritte (b) bis (d).

## Revendications

1. Procédé comportant :
a) la fourniture d'un substrat résiduel (20, 60) composé d'une première matière ;
b) le dépôt d'une couche (30, 64) composée d'une seconde matière par-dessus au moins une partie du substrat résiduel, la seconde matière étant sensiblement similaire, par sa composition, à la première matière, le substrat résiduel et la couche de seconde matière constituant un corps d'une pièce (36) ;
c) le dépôt, sur le corps, par un procédé de dépôt, d'un revêtement de protection (38) contre les agressions extérieures ;
dans lequel :
pour l'étape (b), la couche est déposée par un processus de dépôt choisi parmi le dépôt en phase vapeur, l'implantation ionique par immersion plasma, le dépôt par arc cathodique, la pulvérisation et des combinaisons de ceux-ci ;
pour l'étape (c), le processus de dépôt est choisi parmi le dépôt en phase vapeur, le dépôt par arc cathodique et des combinaisons de ceux-ci, le procédé comportant en outre :
d) l'utilisation d'un traitement thermique pour favoriser la formation d'une liaison intégrale entre le substrat résiduel et la couche à une interface (32) entre ceux-ci, le traitement thermique comprenant l'exposition, pendant 2 à 24 heures, du substrat résiduel et de la couche déposée à des températures de 816°C à 1260°C.

2. Procédé selon la revendication 1, comportant en outre :
e) le traitement d'une surface (52) du corps revêtu avec un processus de traitement de surface de façon que la surface du corps revêtu acquière au moins une caractéristique de surface voulue.

3. Procédé selon la revendication 1 ou 2, comportant en outre :
f) avant (b), l'évaluation d'une épaisseur de paroi du substrat résiduel (20, 60) en comparaison d'une épaisseur minimale prédéterminée de paroi, une quantité de seconde matière déposée en (b) dépendant au moins partiellement de l'épaisseur évaluée de la paroi, dans lequel, si l'épaisseur évaluée de la paroi est inférieure à l'épaisseur minimale prédéterminée de paroi, la seconde matière est déposée en quantité suffisante pour réaliser au moins l'épaisseur minimale de paroi.

4. Procédé selon l'une quelconque des revendications précédentes, comportant en outre :
g) à la suite de (c), l'utilisation de la pièce revêtue (36) dans un moteur à turbine à gaz.

5. Procédé selon la revendication 4, comportant en outre : h) à la suite de (g) l'enlèvement du revêtement de protection (38) contre les agressions extérieures déposé et d'au moins une partie de la couche déposée.

6. Procédé selon la revendication 5, comportant en outre :
i) à la suite de (h), la répétition des étapes (b) à (d).
